# EUROPEAN PATENT SPECIFICATION

(11) **EP 4 645 374 B1**
(45) Date of publication and mention of the grant of the patent: **14.10.2026**
(21) Application number: 23928192.6
(22) Date of filing: 01.06.2023
(51) Int. Cl.: H10W 70/60, H10W 90/00, H10W 90/10, H10W 90/20, H10P 72/70, H10W 72/00, H10W 74/01, H10W 74/15, H10W 74/10

(54) **A SYSTEM-IN-PACKAGE STRUCTURE AND METHOD FOR MANUFACTURING SAME**
EINE SYSTEM-IN-PAKET-STRUKTUR UND VERFAHREN ZU DEREN HERSTELLUNG
STRUCTURE DE SYSTÈME EN BOÎTIER ET PROCÉDÉ DE FABRICATION DE CELLE-CI

(30) Priority: 17.03.2023 CN 202310264780
(43) Date of publication of application: 05.11.2025
(73) Proprietor: SJ Semiconductor (Jiangyin) Corporation, Jiangyin City Wuxi, Jiangsu 214437 (CN)
(72) Inventor: CHEN, Yenheng, Wuxi, Jiangsu 214437 (CN); LIN, Chengchung, Wuxi, Jiangsu 214437 (CN)
(74) Representative: Canzler & Bergmeier Patentanwälte Partnerschaft mbB
(86) International application number: PCT/CN2023/097803
(87) International publication number: WO 2024/192885

(56) References cited:
- CN-A- 105 742 262
- CN-A- 105 742 262
- CN-A- 107 359 142
- CN-A- 114 284 242
- CN-A- 115 132 593
- US-A1- 2009 302 439
- US-A1- 2022 278 087

## Description

### FIELD OF TECHNOLOGY

The present disclosure relates to semiconductor packaging, and in particular to a system-in-package (SiP) structure and a method for manufacturing the same.

### BACKGROUND

As end users demand smaller, faster, more energy-efficient, and higherperforming devices, integrating more functionalities into a single chip inevitably has become an important trend in the future of semiconductor packaging technology. From an architectural perspective, System-in-Package (SiP) refers to the integration of multiple functional chips - including processors, memory, and other functional chips - into a single package to form a standardized unit that performs specific functions. Once the standardized package is formed, it must be interconnected with power modules and passive components (such as LEDs or vertical-cavity surface-emitting lasers) via a printed circuit board (PCB).

In SiP packaging, chips with different precision and process requirements (e.g., logic chips, memory chips, power chips) are interconnected using different methods: chips with low bump pitch are directly bonded to PCB; chips with medium bump pitch are connected to PCB through a redistribution layer (RDL); chips with high bump pitch are connected to RDL through TSV bridging substrates (i.e., bridging substrates with through-silicon vias), and then further connected to PCB via RDL; ultimately, all the different types of chips are interconnected with PCB. As examplified in US 2022/278087 A1. However, since PCBs are usually made of polyester-based materials, they tend to warp under stress as their size and load increase, leading to yield loss. Moreover, the complete manufacturing process - from initial chip fabrication to final bonding of components onto PCB to form a finished SiP device - typically involves three semiconductor production stages: Stage 1. Chip fabrication; Stage 2. Packaging of highand/or medium-bump-pitch chips interconnected via the RDL; Stage 3. Interconnection of low-pitch chips and RDLs (bearing high-pitch chips) with the PCB. These three stages are usually handled by three separate levels of manufacturing facilities. The production process is complicated, involving intricate coordination among the facilities. The interaction is often inefficient, communication is poor, and the product validation cycle is long, all of which hinder rapid product development, so as to meet the need for effectively going through multiple manufacturing facilities during fabrication.

### SUMMARY

The present disclosure provides a SiP structure and a method for manufacturing the same.

The method includes:
S1. providing a temporary carrier and forming a redistribution layer on an upper surface of the temporary carrier;
S2. providing one or more TSV bridging substrates and one or more first-type chips, and bonding the TSV bridging substrates and the first-type chips to the upper surface of the redistribution layer, respectively;
S3. providing one or more second-type chips, and bonding the second-type chips to the upper surface of the TSV bridging substrates, wherein the solder bump pitch of the second-type chips is higher than that of the first-type chips (the solder bump pitch refers to the spacing between solder bumps for connections, a smaller pitch allows for a higher density of interconnections);
S4. forming a first molding compound layer on the upper surface of the redistribution layer, filling gaps among the first and second chips and TSV bridging substrates;
S5. removing the temporary carrier from the lower surface of the redistribution layer, providing a plurality of PCB substrates, and bonding the plurality of PCB substrates to the lower surface of the redistribution layer;
S6. providing a plurality of third-type chips, and bonding the plurality of third-type chips to the lower surface of the plurality of PCB substrates, wherein the solder bump pitch of the third-type chips is lower than that of the first-type chips; and
S7. forming a second molding compound layer on a lower surface of the redistribution layer, filling gaps among the PCB substrates and the third-type chips;
Optionally, after S4 and before S5, the method further includes:
   S41. thinning the first molding compound layer until exposing the upper surface of the first-type chips or the second-type chips, whichever is higher.

Optionally, after S4 and before S5, the method further includes:
S42. disposing a heat sink above the upper side of the redistribution layer, wherein the heat sink encapsulates both the first-type chips and the second-type chips therein.

Optionally, after S7, the method further includes:
S8. forming a trench in the second molding compound layer, wherein the trench exposes a portion of a surface of one of the plurality of PCB substrates;
S9. providing one or more connection plugs, and bonding the connection plugs to the plurality of PCB substrates within the trench.

Optionally, in S2, a number of the second-type chips is greater than or equal to two; in S3, a number of second-type chips is greater than or equal to two; one or more of the second-type chips is bonded to two or more of the TSV bridging substrates.

Optionally, one or more of the second-type chips is bonded to two or more of the PCB bridging substrates.

The present disclosure also provides a SiP structure, the structure includes:
a redistribution layer, one or more TSV bridging substrates, one or more first-type chips, one or more second-type chips, a first molding compound layer, a plurality of PCB substrates, a plurality of third-type chips, and a second molding compound layer; wherein a solder bump pitch of the first-type chips is lower than that of the second-type chips but higher than that of the third-type chips;
the TSV bridging substrates and the first-type chips are directly bonded to an upper surface of the redistribution layer;
the second-type chips are bonded to an upper surface of the TSV bridging substrates;
the first molding compound layer is formed on the upper surface of the redistribution layer and encapsulates the first-type chips and the second-type chips;
the plurality of PCB substrates are bonded to a lower surface of the redistribution layer;
the plurality of third-type chips are bonded to a lower surface of the plurality of PCB substrates; and
the second molding compound layer is formed on the lower surface of the redistribution layer and encapsulates the plurality of third-type chips.

Optionally, the SiP structure further includes a heat sink disposed on the upper surface of the redistribution layer, wherein the heat sink encapsulates the first molding compound layer.

Optionally, the SiP structure further includes one or more connection plugs, wherein a trench is formed in the second molding compound layer exposing a portion of the plurality of PCB substrates; wherein the connection plugs are disposed in the trench and bonded to the plurality of PCB substrates.

Optionally, a number of the TSV bridging substrates is greater than or equal to two, and a number of the second-type chips is greater than or equal to two, wherein one or more of the second-type chips is simultaneously bonded to two or more of the TSV bridging substrates.

Optionally, one or more of the second-type chips is bonded to two or more of the PCB bridging substrates.

As described above, the SiP structure and the method for manufacturing the same provided by the present disclosure offer the following advantages:
1. A plurality of small PCB substrates are used in place of a large monolithic PCB, which improves the manufacturing yield of the PCB without compromising interconnection functionality. This approach reduces fabrication costs and enhances the overall yield of the packaging process.
2. The redistribution layer (RDL) serves as the primary interconnection layer for the chips. Medium bump pitch chips are directly bonded to either sides of the RDL; high bump pitch chips are connected to the RDL via a plurality of small TSV bridging substrates; and low bump pitch chips are indirectly connected to the RDL through a plurality of small PCB substrates. This structure occupies minimal space and achieves high spatial utilization.
3. Since small PCB substrates are used instead of a large monolithic PCB, each small PCB can be directly bonded to the RDL during the packaging process. After bonding, low bump pitch chips that require direct connection to the PCB can also be directly bonded to the small PCBs. The interconnection processes for low-, medium-, and high-bump-pitch chips can all be completed within the same manufacturing facility, thereby reducing production steps, lowering manufacturing costs, and improving product development efficiency.

### BRIEF DESCRIPTION OF THE DRAWINGS

FIG. 1 shows a flowchart illustrating a method for manufacturing a SiP structure according to the present disclosure.
FIG. 2 shows a schematic structural diagram illustrating a structure after forming a redistribution layer according to the present disclosure.
FIG. 3 shows a schematic structural diagram illustrating a structure after bonding the first-type chips and the TSV bridging substrates to the redistribution layer according to the present disclosure.
FIG. 4 shows a schematic structural diagram illustrating a structure after bonding the second-type chips with the TSV bridging substrates according to an embodiment of the present disclosure.
FIG. 5 shows a schematic structural diagram illustrating a structure after forming a first molding compound layer according to the present disclosure.
FIG. 6 shows a schematic structural diagram illustrating a structure after thinning the first molding compound layer according to the present disclosure.
FIG. 7 shows a schematic structural diagram illustrating a structure after forming a heat sink according to the present disclosure.
FIG. 8 shows a schematic structural diagram illustrating a structure after removing the temporary carrier according to the present disclosure.
FIG. 9 shows a schematic structural diagram illustrating a structure after bonding the plurality of PCB substrates with the redistribution layer according to the present disclosure.
FIG. 10 shows a schematic structural diagram illustrating a structure after bonding the plurality of third-type chips with the plurality of PCB substrates according to the present disclosure.
FIG. 11 shows a schematic structural diagram illustrating a structure after formation of a second molding compound layer according to the present disclosure.
FIG. 12 shows a schematic structural diagram illustrating a structure after forming connection plugs according to the present disclosure.

### Reference Numerals

- 10: System-in-Package (SiP)
- 110: Temporary Carrier
- 111: Release Layer
- 100: Redistribution layer
- 200: TSV Bridging Substrate
- 201-203: First TSV Bridging Substrate to Third TSV Bridging Substrate
- 300: First-type Chip
- 400: Second-type Chip
- 401~404: Four Second-type chips with different solder bump pitches
- 500: First Molding Compound Layer
- 600: PCB Substrate
- 601~603: First PCB Substrate to Third PCB Substrate
- 700: Third-type Chip
- 701-703: Three Third-type Chips with different solder bump pitches
- 710: Connecting plugs
- 800: Second Molding Compound Layer
- 900: Heat Sink

### DETAILED DESCRIPTION

The embodiments of the present disclosure will be described below. Those skilled can easily understand advantages and effects of the present disclosure according to contents disclosed by the specification. The present disclosure can also be implemented or applied through other different exemplary embodiments. Various modifications or changes can also be made to all details in the specification based on different points of view and applications without departing from the spirit of the present disclosure.

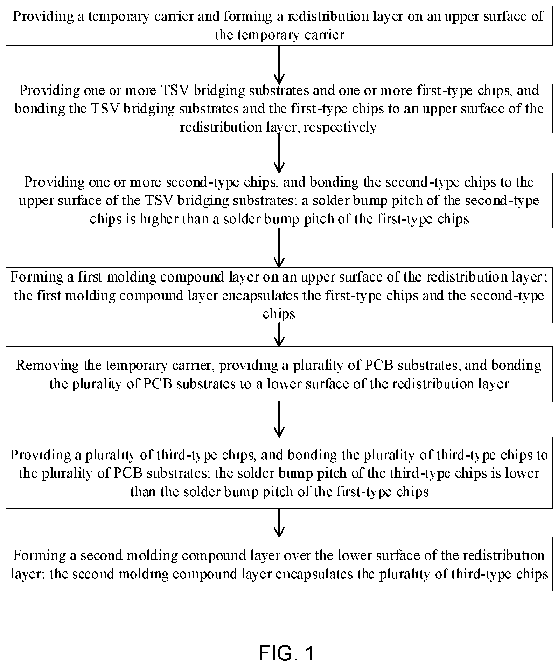

Refer to FIGs. 1-12. It should be noted that the drawings provided in this disclosure only illustrate the basic concept of the present disclosure in a schematic way, so the drawings only show the components closely related to the present disclosure. The drawings are not necessarily drawn according to the number, shape and size of the components in actual implementation; during the actual implementation, the type, quantity and proportion of each component can be changed as needed, and the components' layout may also be more complicated.

The present disclosure provides a method for manufacturing a SiP structure 10. As shown in FIG. 1, the method includes steps S1 to S7. Specifically, steps S8 to S9 are also included.

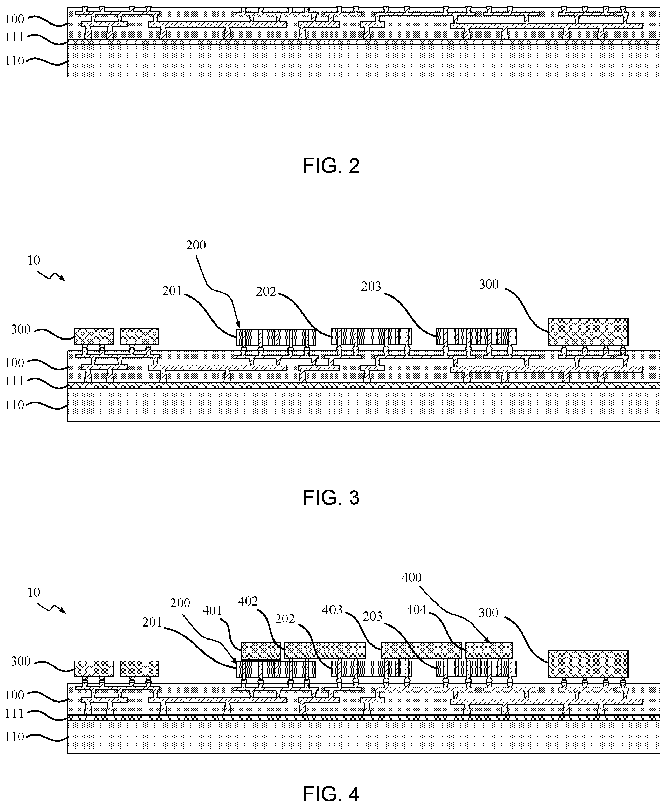

S1. A temporary carrier 110 is provided. As shown in FIG. 2, a redistribution layer 100 is formed on an upper surface of the temporary carrier 110.

In the present disclosure, the temporary carrier 110 may be a glass carrier, ceramic carrier, or the like. The redistribution layer 100 may be a single-layer or a multi-layer redistribution layer.

Specifically, as shown in FIG. 2, before forming the redistribution layer 100 on the upper surface of the temporary carrier 110, a release layer 111 is formed on the upper surface of the temporary carrier 110.

In the present disclosure, an upper surface of the release layer 111 serves as the upper surface of the temporary carrier 110. That is, the redistribution layer 100 is formed on the upper surface of the release layer 111; the release layer 111 may be formed on the temporary carrier 110 by a process such as spin coating; the release layer 111 may be made of an adhesive, such as UV adhesive, photothermal conversion adhesive, or other types of bonding materials; the release layer 111 can be decomposed under photothermal energy, thereby allowing the temporary carrier 110 to be detached from the overlying structure formed in the subsequent steps.

Steps S2 to S3: First, as shown in FIG. 3, one or more TSV bridging substrates 200 and one or more first-type chips 300 are provided. The TSV bridging substrates 200 and the first-type chips 300 are respectively bonded to the upper surface of the redistribution layer 100. Next, as shown in FIG. 4, one or more second-type chips 400 are provided and bonded to the TSV bridging substrates 200. The solder bump pitch of the second-type chips 400 is lower than that of the first-type chips 300.

In the present disclosure, the first-type chips 300 may be, for example, capacitor dies, resistor dies, or inductor dies. The solder bump pitch of such dies (typically in the range of 1 µm to 20 µm) matches the line width and spacing of the redistribution layer (RDL), which is generally between 1 µm and 20 µm (e.g., a line pitch of 2 µm). Therefore, the first-type chips 300 can be directly bonded to the RDL.

The second-type chips 400 may be, for example, logic dies (e.g., CPU, GPU, PCIe), memory dies (e.g., DRAM, SRAM), or input/output (I/O) dies. These second-type chips typically have higher solder bump pitches than the first-type chips. In practical use, second-type chips are better suited to first connect to TSV bridging substrates that feature finer line widths and spacings (typically less than 1 µm, e.g., as small as 0.2 µm or as large as 0.8 µm), and then connect to the redistribution layer 100 via the TSV bridging substrates. As such, the solder bump pitch of the second-type chips 400 is typically less than 1 µm.

It is noted that large-size TSV bridging substrates 200 generally have low fabrication yield and high manufacturing cost. Therefore, the present disclosure preferentially adopts multiple smaller TSV bridging substrates 200. Taking the example of three TSV bridging substrates and four second-type chips, as shown in FIG. 4, these four second-type chips - 401, 402, 403, and 404 - have different solder bump pitches (401 and 402 have the same bump pitch, 403 and 404 have the same bump pitch, and the bump pitch of 401 is lower than that of 403). The three TSV bridging substrates include a first TSV bridging substrate 201, a second TSV bridging substrate 202, and a third TSV bridging substrate 203. The TSV pitch in the first bridging substrate 201 is higher than that in the third bridging substrate 203. The second bridging substrate 202 includes two different TSV pitches, which are respectively comparable to those in 201 and 203.nAs shown in FIG. 4, the first bridging substrate 201 is bonded to the chip 401 with lower bump pitch, the third bridging substrate 203 is bonded to the chip 404 with higher bump pitch, and the second bridging substrate 202 is bonded on opposite ends to chips 403 and 404, which have different bump pitches. In this configuration, the second bridging substrate 202 functions as a signal transmission bridge for the high-pitch interconnection between 403 and 404, thereby meeting the design requirements. Compared with using a single large bridging substrate, this design significantly reduces production costs and improves process yield.

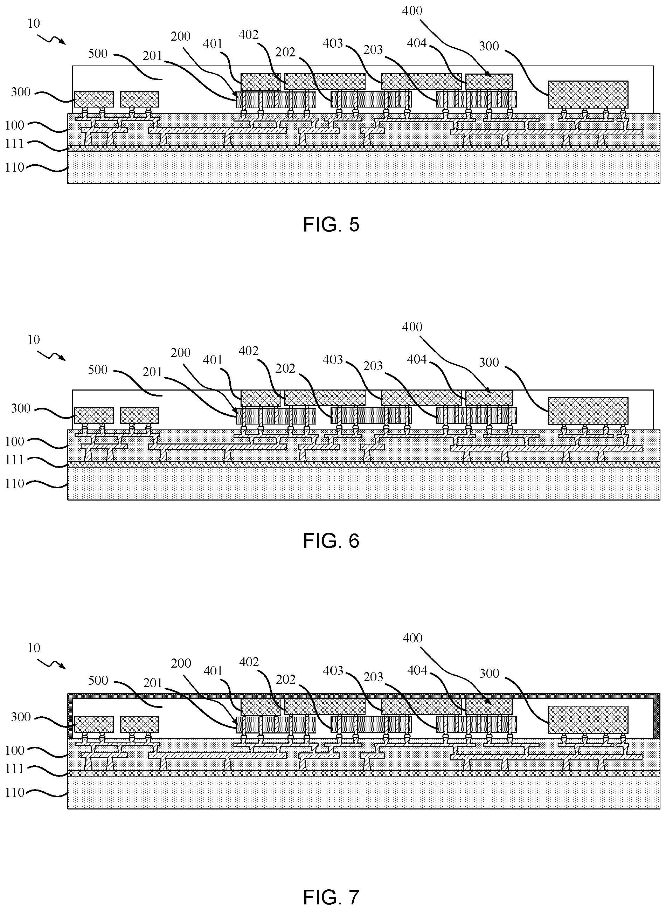

Step S4: As shown in FIG. 5, a first molding compound layer 500 is formed on the upper surface of the redistribution layer 100.

In the present disclosure, the method for forming the first molding compound layer 500 includes, but is not limited to, compression molding, transfer molding, liquid encapsulation, vacuum lamination, and spin coating. The material used for the molding compound may include, but is not limited to, polyimide, silicone, and epoxy resin.

Specifically, after Step S4, the method for manufacturing the SiP structures further includes Steps S41 and S42.

Step S41: As illustrated in FIG. 6, the first molding compound layer 500 is thinned until the upper surface of the first-type chips 300 and/or the upper surface of the second-type chips 400 is exposed.

In the present disclosure, the thinning process for the first molding compound layer 500 may include, but is not limited to, backside grinding. After thinning, the upper surface of the first molding compound layer 500 exposes the top surface of the chip(s) (as illustrated, the top surface of the second-type chips is exposed). It is worth noting that, in actual applications, the height levels of the top surfaces of the first-type chips and second-type chips may vary after bonding. Therefore, the first molding compound layer 500 only needs to be thinned down to the height of the tallest chip.

Step S42: As shown in FIG. 7, a heat sink 900 is provided above the redistribution layer 100. The heat sink 900 encapsulates multiple first-type chips 300 and second-type chips 400, allowing it to dissipate heat generated by the chips through thermal conduction.

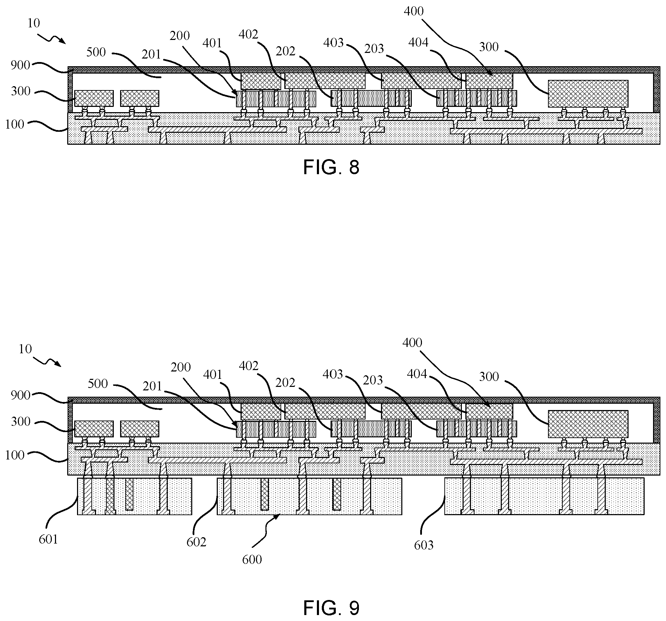

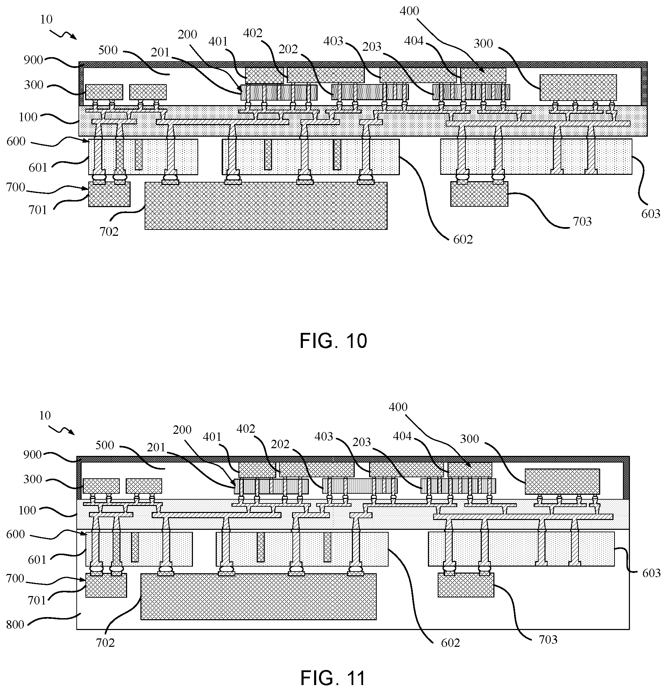

Steps S5 to S6: First, as shown in FIG. 8, the temporary carrier 110 is removed. Then, as shown in FIG. 9, a plurality of PCB substrates 600 are provided and bonded to the lower surface of the redistribution layer 100. Next, as shown in FIG. 10, a plurality of third-type chips 700 are provided and bonded to the corresponding PCB substrates 600. The solder bump pitch of the plurality of third-type chips 700 is lower than that of the first-type chips 300.

In the present disclosure, during the removal of the temporary carrier 110, heating and/or light exposure can first be applied to reduce the adhesion of the release layer 111, thereby enabling removal of the temporary carrier 110. Subsequently, peeling, light exposure, or other methods can be used to strip off the release layer 111. Alternatively, a laser debonding process may be directly employed to separate the redistribution layer 100 from the temporary carrier 110. The release layer 111 is vaporized by laser energy, effectively detaching the temporary carrier 110 from the redistribution layer 100. This technique offers high processing precision and results in minimal residual contamination.

In the present disclosure, the plurality of third-type chips 700 may be, for example, power module chips or passive components (such as pulsewidth modulation chips). Due to their lower solder bump pitch, they are suitable for first being bonded to PCB substrates with larger line widths and spacings (typically greater than 20 µm, for example, 50 µm or 100 µm), and then electrically connected to the redistribution layer 100 via the PCB substrates. Therefore, the solder bump pitch range of the third-type chips 700 is greater than 20 µm. In traditional packaging structures, the first-type chips, second-type chips, and third-type chips are typically interconnected via a single large PCB substrate. However, large PCBs are prone to warping, which often results in reduced process yield. In contrast, the present disclosure does not adopt such a conventional packaging structure. Instead, it uses the redistribution layer 100 as the interconnection bridge among the first-type chips, second-type chips, and third-type chips 700. This not only satisfies the signal interconnection requirements between chips, but also offers shorter signal transmission paths compared to PCB-based interconnections. As a result, it saves space and improves signal integrity, while still meeting the design specifications of the device. Moreover, the use of multiple smaller PCB substrates to interconnect the third-type chips with the redistribution layer 100 effectively mitigates the warping issue associated with large PCB boards. In addition, after the first-type and second-type chips are packaged with the redistribution layer, the multiple small-sized PCB substrates can be directly bonded to the redistribution layer within the same manufacturing facility. Following this, the third-type chips can be bonded to the PCB substrates, thereby completing all packaging processes. This approach reduces the number of processing steps and eliminates the need to transfer materials to other facilities, thereby streamlining production and improving overall manufacturing efficiency.

As an example, three PCB substrates 600 and three third-type chips 700 are provided. As shown in FIG. 10, the three third-type chips - 701, 702, and 703 - each have different solder bump pitches (chips 702 and 703 share the same bump pitch, while chip 701 has a higher bump pitch than chip 703). However, all three chips have a bump pitch greater than 20 µm, meaning that chips 701, 702, and 703 must all be interconnected to the RDL layer via PCB substrates. The three PCB substrates include a first PCB substrate 601, a second PCB substrate 602, and a third PCB substrate 603. The first PCB substrate 601 features two regions with different high and low bump pitches: the higher-pitch region is bonded to chip 701, and the lowerpitch region is bonded to chip 702. The second PCB substrate 602 is also bonded to chip 702. The third PCB substrate 603 is bonded to chip 703. Each of the three PCB substrates, with varying solder bump pitches, is bonded to third-type chips with corresponding solder bump pitches. This configuration not only satisfies the design requirement of interconnecting the third-type chips with both the first-type and second-type chips, but also avoids the drawbacks of high cost and low manufacturing yield associated with large PCB substrates.

Step S7: As shown in FIG. 11, a second molding compound layer 800 is formed on the lower surface of the redistribution layer 100.

In the present disclosure, the method for forming the second molding compound layer 800 includes, but is not limited to: compression molding, transfer molding, liquid encapsulation, vacuum lamination, and spin coating. The molding materials may include, but are not limited to, polyimide, silicone, and epoxy resin.

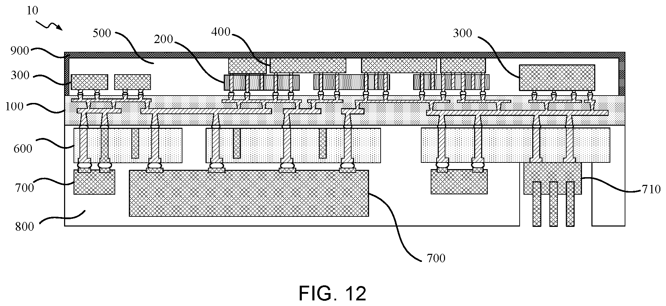

Steps S8 to S9: As shown in FIG. 12, a trench is first formed within the second molding compound layer, exposing a portion of the surface of the PCB substrate.

Then, one or more connection plugs 710 are provided and bonded to the PCB substrate within the trench.

In the present disclosure, for example, a laser cutting process is used to form the trench. The bottom of the trench corresponds to the lower surface of the PCB substrate, and the trench is configured to expose at least part of the solder pads of the PCB substrate, allowing the connection plugs to be electrically bonded to the PCB substrate. Through the connection plugs 710, the first-type chips, second-type chips, and third-type chips in the SiP structure 10 are electrically connected to an external power supply for receiving an operating voltage.

Correspondingly, the present disclosure also provides a SiP structure 10, as illustrated in FIG. 12. The SiP structure 10 includes: a redistribution layer 100, one or more TSV bridging substrates 200, one or more first-type chips 300, one or more second-type chips 400, a first molding compound layer 500, a plurality of PCB substrates 600, a plurality of third-type chips 700, and a second molding compound layer 800. The solder bump pitch of the first-type chips 300 is lower than that of the second-type chips 400, but higher than that of the plurality of third-type chips 700; the TSV bridging substrate 200 and the first-type chip 300 are bonded to an upper surface of the redistribution layer 100; the second-type chips 400 are bonded to an upper surface of the TSV bridging substrates 200; the first molding compound layer 500 is formed on the upper surface of the redistribution layer 100 and encapsulates the first-type chips 300 and the second-type chips 400; the plurality of PCB substrates 600 are bonded to a lower surface of the redistribution layer 100; the plurality of third-type chips 700 are bonded to a lower surface of the plurality of PCB substrates 600; the second molding compound layer 800 is formed on the lower surface of the redistribution layer 100 and encapsulates the plurality of third-type chips 700.

In the present disclosure, the wiring pitch of the redistribution layer 100 is lower than that of the TSV bridging substrate 200. When the number of TSV bridging substrates 200 and second-type chips 400 is greater than or equal to two, the second-type chips 400 can communicate with each other via TSV bridging substrates of different wiring pitches. This results in shorter interconnect paths and better communication quality, thereby improving yield and reducing manufacturing cost. The wiring pitch of the plurality of PCB substrates 600 is lower than that of the redistribution layer 100. The plurality of third-type chips 700 can communicate with other chips through PCB substrates with different solder bump pitches, which also helps improve yield and reduce production cost.

It should be noted that the present disclosure merely provides an illustrative example where the first-type chips 300 and second-type chips 400 are positioned on the upper side of the redistribution layer 100, and the third-type chips 700 are positioned on the lower side. In practical packaging designs: the first-type chips may be disposed on either the upper or lower side of the redistribution layer; the second-type chips may also be disposed on either side;
likewise, the third-type chips may be located on either side of the redistribution layer.

Specifically, the number of TSV bridging substrates 200 is greater than or equal to two, and the number of second-type chips 400 is greater than or equal to two, with one or more second-type chips 400 bonded to two or more TSV bridging substrates 200 simultaneously.

In the present disclosure, as shown in FIG. 4, when the number of TSV bridging substrates 200 and second-type chips 400 is greater than or equal to two, a second-type chip 400 may be bridged across two TSV bridging substrates 200. The TSV bridging substrates 200 connected to this bridged second-type chip 400 may either have a single TSV through pitch or multiple different TSV through pitches.

Specifically, one or more of the plurality of third-type chips 700 is bonded to two or more of the plurality of PCB substrates 600 simultaneously.

As shown in FIG. 10, a third-type chip may be bridged across two PCB substrates, and the PCB substrates connected to this bridged third-type chip may have a single solder bump pitch or multiple different solder bump pitches.

Furthermore, the SiP structure 10 also includes a heat dissipation plate 900, which is disposed on the upper surface of the redistribution layer 100, encapsulating the first molding compound layer 500. The heat dissipation plate 900 serves to conduct and dissipate heat generated by the chips. It should be noted that the heat dissipation plate 900 may be positioned only on the upper side of the redistribution layer 100, only on the lower side, or on both sides simultaneously.

Specifically, the SiP structure 10 further includes one or more connection plugs; a trench is formed in the second molding compound layer 800 exposing a portion of the plurality of PCB substrates; the connection plugs 710 are disposed in the trench and bonded to the plurality of PCB substrates 600.

In the present disclosure, the connection plugs 710 may be used, for example, to connect to a voltage source and supply an operating voltage to the SiP structure 10. The number of connection plugs 710 can also be more than one to accommodate various system voltage requirements.

In summary, the SiP structure and the method for manufacturing the same provides by the present disclosure provide the following advantages: 1. Multiple small PCB substrates are used in place of a single large PCB substrate. This substitution enhances the manufacturing yield of the PCB substrates without compromising interconnection functionality, thereby reducing fabrication cost and improving packaging process yield. 2. The redistribution layer (RDL) serves as an interconnection layer that connects various chips. On both sides of the RDL, medium solder bump pitch chips are directly connected to the RDL, high solder bump pitch chips are connected to the RDL through multiple small TSV bridging substrates, and low solder bump pitch chips are connected to the RDL via multiple small PCB substrates. This architecture minimizes space usage and maximizes space efficiency. 3. Since small-sized PCB substrates are used instead of a single large PCB, each PCB piece can be directly bonded to the redistribution layer during packaging. After bonding, low-solder-bump pitch chips that need to be directly connected to the PCB can be bonded in the same factory. As a result, the interconnection processes for low, medium, and high bump pitch chips can all be completed within the same manufacturing facility, thereby reducing production steps, lowering manufacturing costs, and enhancing product development efficiency.

## Claims

1. A method for manufacturing a system-in-package (SiP) structure, comprising:
S1. providing a temporary carrier and forming a redistribution layer on an upper surface of the temporary carrier;
S2. providing one or more TSV bridging substrates and one or more first-type chips, and bonding the TSV bridging substrates and the first-type chips to an upper surface of the redistribution layer, respectively;
S3. providing one or more second-type chips, and bonding the second-type chips to the upper surface of the TSV bridging substrates, wherein a solder bump pitch of the second-type chips is higher than a solder bump pitch of the first-type chips;
S4. forming a first molding compound layer on an upper surface of the redistribution layer, wherein the first molding compound layer encapsulates the first-type chips and the second-type chips;
S5. removing the temporary carrier, providing a plurality of PCB substrates, and bonding the plurality of PCB substrates to a lower surface of the redistribution layer;
S6. providing a plurality of third-type chips, and bonding the plurality of third-type chips to the plurality of PCB substrates, wherein the solder bump pitch of the third-type chips is lower than the solder bump pitch of the first-type chips; and
S7. forming a second molding compound layer over the lower surface of the redistribution layer, wherein the second molding compound layer encapsulates the plurality of third-type chips.

2. The method according to claim 1, wherein after S4 and before S5, the method further comprises:
S41. thinning the first molding compound layer until exposing an upper surface of the first-type chips or the second-type chips, whichever is higher.

3. The method according to claim 1, wherein after S4 and before S5, the method further comprises:
S42. disposing a heat sink over the upper surface of the redistribution layer, wherein the heat sink encapsulates the one or more first-type chips and the one or more second-type chips therein.

4. The method according to claim 1, wherein after S7, the method further comprises:
S8. forming a trench in the second molding compound layer, wherein the trench exposes a portion of a surface of the plurality of PCB substrates; and
S9. providing one or more connection plugs, and bonding the connection plugs to the plurality of PCB substrates within the trench.

5. The method according to claim 1, wherein in S2, a number of the TSV bridging substrates is greater than or equal to two; in S3, a number of the second-type chips is greater than or equal to two; and wherein one or more of the second-type chips is bonded to two or more of the TSV bridging substrates.

6. The method according to claim 1, wherein in S6, one or more of the plurality of third-type chips is simultaneously bonded to two or more of the plurality of PCB substrates.

7. A SiP structure, wherein the structure comprises:
a redistribution layer, one or more TSV bridging substrates, one or more first-type chips, one or more second-type chips, a first molding compound layer, a plurality of PCB substrates, a plurality of third-type chips, and a second molding compound layer; wherein a solder bump pitch of the first-type chips is lower than a solder bump pitch of the second-type chips but higher than that of the third-type chips;
wherein the TSV bridging substrates and the first-type chips are directly bonded to an upper surface of the redistribution layer;
wherein the second-type chips are bonded to an upper surface of the TSV bridging substrates;
wherein the first molding compound layer is formed over the upper surface of the redistribution layer and encapsulates the first-type chips and the second-type chips;
wherein the plurality of PCB substrates are bonded to a lower surface of the redistribution layer;
wherein the plurality of third-type chips are bonded to a lower surface of the plurality of PCB substrates; and
wherein the second molding compound layer is formed over the lower surface of the redistribution layer and encapsulates the plurality of third-type chips.

8. The structure according to claim 7, wherein the SiP structure further comprises a heat sink disposed over the upper surface of the redistribution layer, wherein the heat sink encapsulates the first molding compound layer.

9. The structure according to claim 7, wherein the SiP structure further comprises one or more connection plugs, wherein a trench is formed in the second molding compound layer exposing a portion of the plurality of PCB substrates; and wherein the connection plugs are disposed in the trench and bonded to the plurality of PCB substrates.

10. The structure according to claim 7, wherein a number of the TSV bridging substrates is greater than or equal to two, and a number of the second-type chips is greater than or equal to two, and wherein two or more of the second-type chips are similarly bonded to two or more of the TSV bridging substrates.

11. The structure according to claim 7, wherein the plurality of third-type chips is similarly bonded to two or more of the plurality of PCB substrates.

## Patentansprüche

1. Verfahren zum Fertigen einer System-in-Package (SiP) Struktur, umfassend:
S1. Bereitstellen eines temporären Trägers und Bilden einer Umverteilungsschicht auf einer oberen Oberfläche des temporären Trägers;
S2. Bereitstellen eines oder mehrerer TSV überbrückender Substrate und eines oder mehrerer Chips des ersten Typs und Bonden der TSV überbrückenden Substrate und der Chips des ersten Typs jeweils an eine obere Oberfläche der Umverteilungsschicht;
S3. Bereitstellen eines oder mehrerer Chips des zweiten Typs und Bonden der Chips des zweiten Typs an die obere Oberfläche der TSV überbrückenden Substrate, wobei ein Löthubbel-Abstand der Chips des zweiten Typs höher ist als ein Löthubbel-Abstand der Chips des ersten Typs;
S4. Bilden einer ersten Formmassenschicht auf einer oberen Oberfläche der Umverteilungsschicht, wobei die erste Formmassenschicht die Chips des ersten Typs und die Chips des zweiten Typs verkapselt;
S5. Entfernen des temporären Trägers, Bereitstellen einer Vielzahl von PCB-Substraten und Bonden der Vielzahl von PCB-Substraten an eine untere Oberfläche der Umverteilungsschicht;
S6. Bereitstellen einer Vielzahl von Chips des dritten Typs und Bonden der Vielzahl von Chips des dritten Typs an die Vielzahl von PCB-Substraten, wobei der Löthubbel-Abstand der Chips des dritten Typs niedriger ist als der Löthubbel-Abstand der Chips des ersten Typs; und
S7. Bilden einer zweiten Formmassenschicht über der unteren Oberfläche der Umverteilungsschicht, wobei die zweite Formmassenschicht die Vielzahl von Chips des dritten Typs verkapselt.

2. Verfahren nach Anspruch 1, wobei nach S4 und vor S5 das Verfahren ferner umfasst:
S41. Ausdünnen der ersten Formmassenschicht bis zum Freilegen einer oberen Oberfläche der Chips des ersten Typs oder der Chips des zweiten Typs, je nachdem, welche höher ist.

3. Verfahren nach Anspruch 1, wobei nach S4 und vor S5 das Verfahren ferner umfasst:
S42. Anordnen einer Wärmesenke über der oberen Oberfläche der Umverteilungsschicht, wobei die Wärmesenke den einen oder die mehreren Chips des ersten Typs und den einen oder die mehreren Chips des zweiten Typs darin verkapselt.

4. Verfahren nach Anspruch 1, wobei nach S7 das Verfahren ferner umfasst:
S8. Bilden eines Grabens in der zweiten Formmassenschicht, wobei der Graben einen Bereich einer Oberfläche der Vielzahl von PCB-Substraten freilegt; und
S9. Bereitstellen eines oder mehrerer Verbindungsstecker und Bonden der Verbindungsstecker an die Vielzahl von PCB-Substraten innerhalb des Grabens.

5. Verfahren nach Anspruch 1, wobei in S2 eine Anzahl der TSV überbrückenden Substrate größer oder gleich zwei ist; in S3 eine Anzahl der Chips des zweiten Typs größer oder gleich zwei ist; und wobei einer oder mehrere der Chips des zweiten Typs an zwei oder mehrere der TSV überbrückenden Substrate gebondet sind.

6. Verfahren nach Anspruch 1, wobei in S6 einer oder mehrere der Vielzahl von Chips des dritten Typs gleichzeitig an zwei oder mehrere der Vielzahl von PCB-Substraten gebondet sind.

7. SiP Struktur, wobei die Struktur umfasst:
eine Umverteilungsschicht, ein oder mehrere TSV überbrückende Substrate, einen oder mehrere Chips des ersten Typs, einen oder mehrere Chips des zweiten Typs, eine erste Formmassenschicht, eine Vielzahl von PCB-Substraten, eine Vielzahl von Chips des dritten Typs und eine zweite Formmassenschicht; wobei ein Löthubbel-Abstand der Chips des ersten Typs niedriger ist als ein Löthubbel-Abstand der Chips des zweiten Typs, aber höher ist als der der Chips des dritten Typs;
wobei die TSV überbrückenden Substrate und die Chips des ersten Typs direkt an eine obere Oberfläche der Umverteilungsschicht gebondet sind;
wobei die Chips des zweiten Typs an eine obere Oberfläche der TSV überbrückenden Substrate gebondet sind;
wobei die erste Formmassenschicht über der oberen Oberfläche der Umverteilungsschicht gebildet ist und die Chips des ersten Typs und die Chips des zweiten Typs verkapselt;
wobei die Vielzahl von PCB-Substraten an eine untere Oberfläche der Umverteilungsschicht gebondet sind;
wobei die Vielzahl von Chips des dritten Typs an eine untere Oberfläche der Vielzahl von PCB-Substraten gebondet sind; und
wobei die zweite Formmassenschicht über der unteren Oberfläche der Umverteilungsschicht gebildet ist und die Vielzahl von Chips des dritten Typs verkapselt.

8. Struktur nach Anspruch 7, wobei die SiP Struktur ferner eine Wärmesenke umfasst, die über der oberen Oberfläche der Umverteilungsschicht angeordnet ist, wobei die Wärmesenke die erste Formmassenschicht verkapselt.

9. Struktur nach Anspruch 7, wobei die SiP Struktur ferner einen oder mehrere Verbindungsstecker umfasst, wobei ein Graben in der zweiten Formmassenschicht gebildet ist, der einen Bereich der Vielzahl von PCB-Substraten freilegt; und wobei die Verbindungsstecker in dem Graben angeordnet und an die Vielzahl von PCB-Substraten gebondet sind.

10. Struktur nach Anspruch 7, wobei eine Anzahl der TSV überbrückenden Substrate größer oder gleich zwei ist und eine Anzahl der Chips des zweiten Typs größer oder gleich zwei ist, und wobei zwei oder mehrere der Chips des zweiten Typs gleichermaßen an zwei oder mehrere der TSV überbrückenden Substrate gebondet sind.

11. Struktur nach Anspruch 7, wobei die Vielzahl von Chips des dritten Typs gleichermaßen an zwei oder mehrere der Vielzahl von PCB-Substraten gebondet sind.

## Revendications

1. Procédé pour fabriquer une structure de système dans un boîtier (SiP), comprenant les étapes consistant à :
S1. fournir un support temporaire et former une couche de redistribution sur une surface supérieure du support temporaire ;
S2. fournir un ou plusieurs substrats de pontage TSV et une ou plusieurs puces de premier type, et lier les substrats de pontage TSV et les puces de premier type à une surface supérieure de la couche de redistribution, respectivement ;
S3. fournir une ou plusieurs puces de second type, et lier les puces de second type à la surface supérieure des substrats de pontage TSV, dans lequel un pas de bossage de soudure des puces de second type est supérieur à un pas de bossage de soudure des puces de premier type ;
S4. former une première couche composé de moulage sur une surface supérieure de la couche de redistribution, dans lequel la première couche composé de moulage encapsule les puces de premier type et les puces de second type ;
S5. enlever le support temporaire, fournir une pluralité de substrats de PCB, et lier la pluralité de substrats de PCB à une surface inférieure de la couche de redistribution ;
S6. fournir une pluralité de puces de troisième type, et lier la pluralité de puces de troisième type à la pluralité de substrats de PCB, dans lequel le pas de bossage de soudure des puces de troisième type est inférieur au pas de bossage de soudure des puces de premier type ; et
S7. former une seconde couche composé de moulage sur la surface inférieure de la couche de redistribution, dans lequel la seconde couche composé de moulage encapsule la pluralité de puces de troisième type.

2. Procédé selon la revendication 1, dans lequel après S4 et avant S5, le procédé comprend en outre les étapes consistant à :
S41. amincir la première couche composé de moulage jusqu'à exposer une surface supérieure des puces de premier type ou des puces de second type, selon celle qui est la plus élevée.

3. Procédé selon la revendication 1, dans lequel après S4 et avant S5, le procédé comprend en outre les étapes consistant à :
S42. disposer un dissipateur thermique sur la surface supérieure de la couche de redistribution, dans lequel le dissipateur thermique encapsule les une ou plusieurs puces de premier type et les une ou plusieurs puces de second type dans celui-ci.

4. Procédé selon la revendication 1, dans lequel après S7, le procédé comprend en outre les étapes consistant à :
S8. former une tranchée dans la seconde couche composé de moulage, dans lequel la tranchée expose une partie d'une surface de la pluralité de substrats de PCB ; et
S9. fournir une ou plusieurs fiches de connexion, et lier les fiches de connexion à la pluralité de substrats de PCB à l'intérieur de la tranchée.

5. Procédé selon la revendication 1, dans lequel dans S2, un nombre des substrats de pontage TSV est supérieur ou égal à deux ; dans S3, un nombre des puces de second type est supérieur ou égal à deux ; et dans lequel une ou plusieurs des puces de second type sont liées à deux ou plus des substrats de pontage TSV.

6. Procédé selon la revendication 1, dans lequel dans S6, une ou plusieurs de la pluralité de puces de troisième type sont simultanément liées à deux ou plus de la pluralité de substrats de PCB.

7. Structure de SiP, dans laquelle la structure comprend :
une couche de redistribution, un ou plusieurs substrats de pontage TSV, une ou plusieurs puces de premier type, une ou plusieurs puces de second type, une première couche composé de moulage, une pluralité de substrats de PCB, une pluralité de puces de troisième type, et une seconde couche composé de moulage ; dans laquelle un pas de bossage de soudure des puces de premier type est inférieur à un pas de bossage de soudure des puces de second type mais supérieur à celui des puces de troisième type ;
dans laquelle les substrats de pontage TSV et les puces de premier type sont directement liés à une surface supérieure de la couche de redistribution ;
dans laquelle les puces de second type sont liées à une surface supérieure des substrats de pontage TSV ;
dans laquelle la première couche composé de moulage est formée sur la surface supérieure de la couche de redistribution et encapsule les puces de premier type et les puces de second type ;
dans laquelle la pluralité de substrats de PCB sont liés à une surface inférieure de la couche de redistribution ;
dans laquelle la pluralité de puces de troisième type sont liés à une surface inférieure de la pluralité de substrats de PCB ; et
dans laquelle la seconde couche composé de moulage est formée sur la surface inférieure de la couche de redistribution et encapsule la pluralité de puces de troisième type.

8. Structure selon la revendication 7, dans laquelle la structure de SiP comprend en outre un dissipateur thermique disposé sur la surface supérieure de la couche de redistribution, dans laquelle le dissipateur thermique encapsule la première couche composé de moulage.

9. Structure selon la revendication 7, dans laquelle la structure de SiP comprend en outre une ou plusieurs fiches de connexion, dans laquelle une tranchée est formée dans la seconde couche composé de moulage exposant une partie de la pluralité de substrats de PCB ; et dans laquelle les fiches de connexion sont disposées dans la tranchée et liées à la pluralité de substrats de PCB.

10. Structure selon la revendication 7, dans laquelle un nombre des substrats de pontage TSV est supérieur ou égal à deux, et un nombre des puces de second type est supérieur ou égal à deux, et dans laquelle deux ou plus des puces de second type sont liées de manière similaire à deux ou plus des substrats de pontage TSV.

11. Structure selon la revendication 7, dans laquelle la pluralité de puces de troisième type sont liées de manière similaire à deux ou plus de la pluralité de substrats de PCB.
